# EUROPÄISCHE PATENTSCHRIFT

(11) **EP 3 243 267 B1**
(45) Veröffentlichungstag und Bekanntmachung des Hinweises auf die Patenterteilung: **12.08.2026**
(21) Anmeldenummer: 15816149.7
(22) Anmeldetag: 17.12.2015
(51) Int. Cl.: H02M 5/45, H03K 5/19

(54) **FREQUENZUMRICHTER**
FREQUENCY CONVERTER
CONVERTISSEUR DE FREQUENCE

(30) Priorität: 09.01.2015 DE 102015200190
(43) Veröffentlichungstag der Anmeldung: 15.11.2017
(73) Patentinhaber: Schmidhauser AG, 8590 Romanshorn (CH)
(72) Erfinder: BISIG, Thomas, 8590 Romanshorn (CH)
(74) Vertreter: Patentanwälte Ruff, Wilhelm, Beier, Dauster & Partner mbB
(86) Internationale Anmeldenummer: PCT/EP2015/080365
(87) Internationale Veröffentlichungsnummer: WO 2016/110393

(56) Entgegenhaltungen:
- EP-A1- 2 477 007
- DE-A1- 10 047 927
- DE-A1- 102009 055 126
- DE-A1- 19 757 688
- US-A1- 2014 097 886

## Beschreibung

Die DE 197 57 688 A1 offenbart eine Wechselrichter-Vorrichtung, bei der Einstelldaten, wie beispielsweise eine Einstellfrequenz, mittels eines E/A-Blocks von einem Benutzer eingestellt werden, wobei diese Einstelldaten anschließend über eine serielle Schnittstelle zu einem Kernmikrocomputer übertragen werden. Der Kernmikrocomputer arbeitet in Folge gemäß den Einstelldaten. In anderer Übertragungsrichtung werden Ist-Werte vom Kernmikrocomputer zum E/A-Block übertragen, der diese Ist-Werte dann visualisiert.

Die DE 10 2009 055 126 A1 offenbart einen Umrichter mit einer Steuereinheit und einer von dieser getrennten Leistungseinheit, die mit der Steuereinheit in Datenverbindung steht. Die Steuereinheit weist eine Sensoreinheit auf.

Die US 2014/097886 A1 offenbart ein System zum Steuern von Leistungshalbleitern.

Die DE 100 47 927 A1 offenbart ein Verfahren zur Vernetzung einer Regelungseinheit mit einem oder mehreren Leistungsteilen mit folgenden Verfahrensschritten: Aufteilung der Rechenleistung einer Antriebsregelung auf eine Regelungselektronik und ein zugeordnetes Leistungsteil, Verbindung der Regelungseinheit und jedes Leistungsteils über eine echtzeitfähige digitale Schnittstelle und Synchronisierung der Kommunikation zwischen der Regelungseinheit und jedem Leistungsteil durch ein digitales Übertragungsprotokoll.

Der Erfindung liegt die Aufgabe zugrunde, einen Frequenzumrichter zur Verfügung zu stellen, der einfach zu fertigen ist und der im Betrieb eine hohe Zuverlässigkeit aufweist.

Die Erfindung löst diese Aufgabe durch einen Frequenzumrichter nach Anspruch 1.

Der Frequenzumrichter weist eine Steuereinheit auf.

Die Steuereinheit weist eine serielle Steuereinheit-Schnittstelle auf.

Die Steuereinheit weist weiter einen Steuereinheit-Taktgeber, beispielsweise in Form eines (Quarz-) Oszillators, zur Erzeugung eines Steuereinheit-Taktes auf. Daten werden über die serielle Steuereinheit-Schnittstelle hinsichtlich ihres Timings in Abhängigkeit von dem Steuereinheit-Takt übertragen. Beispielsweise kann eine Bitrate der Daten von dem Steuereinheit-Takt abhängig sein.

Die Steuereinheit weist weiter einen Steuereinheit-Prozessor auf, der dazu ausgebildet ist, mindestens eine Steuergröße in Abhängigkeit von mindestens einem Istwert zu bestimmen. Der Steuereinheit-Prozessor kann mittels des Steuereinheit-Taktes getaktet sein.

Der Frequenzumrichter weist weiter eine Leistungseinheit auf, die von der Steuereinheit räumlich getrennt sein kann und die in Datenverbindung mit der Steuereinheit steht.

Die Leistungseinheit weist herkömmlich eine Anzahl von Leistungshalbleitern auf, die zur Erzeugung hochfrequenter, beispielsweise pulsweitenmodulierter, Ansteuersignale bzw. Ansteuerspannungen für einen Elektromotor dienen. Die Leistungshalbleiter können beispielsweise derart angesteuert werden, dass sich ein gewünschtes Motordrehmoment, eine gewünschte Motordrehzahl, ein gewünschter Motorstrom, usw. einstellen. Insoweit sei auch auf die einschlägige Fachliteratur verwiesen.

Die Leistungseinheit weist weiter einen Leistungseinheit-Taktgeber zur Erzeugung eines einstellbaren Leistungseinheit-Taktes auf. Der Leistungseinheit-Taktgeber ist ein so genannter DCO (Digitally Controlled Oscillator).

Die Leistungseinheit weist weiter eine serielle Leistungseinheit-Schnittstelle auf, die mit der Steuereinheit-Schnittstelle koppelbar bzw. im Funktionszustand des Frequenzumrichters gekoppelt ist.

Die Steuereinheit und Leistungseinheit können beispielsweise in voneinander getrennten Gehäusen angeordnet sein, wobei die Steuereinheit auf die Leistungseinheit aufsteckbar ist, wobei eine lösbare, mechanisch rastende Verbindung zwischen der Steuereinheit und der Leistungseinheit vorgesehen sein kann. Im aufgesteckten Zustand können die Steuereinheit-Schnittstelle und die Leistungseinheit-Schnittstelle elektrisch miteinander verbunden sein, so dass zwischen der Steuereinheit und der Leistungseinheit über deren jeweilige Schnittstellen Daten bidirektional austauschbar sind.

Die Leistungseinheit weist weiter eine Taktgebereinstelleinheit auf, die unmittelbar oder mittelbar mit der Leistungseinheit-Schnittstelle gekoppelt ist bzw. in Signal- oder Wirkverbindung mit der Leistungseinheit-Schnittstelle steht. Die Taktgebereinstelleinheit ist dazu ausgebildet, in Abhängigkeit von Signalen, und/oder Daten, und/oder Datenpaketen, und/oder (Start-) Bitdauern, und/oder zeitlichen Abständen zwischen spezifischen Bits, und/oder einer Dauer eines Datenpakets, und/oder zeitlichen Abständen zwischen aufeinanderfolgenden Datenpaketen, und/oder zeitlichen Dauern spezifischer Synchronisationsbitmuster, etc., die von der Leistungseinheit auf ihrer Leistungseinheit-Schnittstelle von der Steuereinheit empfangen werden, den Leistungseinheit-Takt einzustellen.

Die Leistungseinheit weist weiter einen Leistungseinheit-Prozessor auf, der dazu ausgebildet ist, die Leistungshalbleiter gegebenenfalls über Leistungshalbleiter-Treiber in Abhängigkeit von der Steuergröße und dem Leistungseinheit-Takt anzusteuern.

Die Leistungseinheit weist weiter mindestens eine Sensoreinheit auf, die dazu ausgebildet ist, den mindestens einen Istwert zu ermitteln.

Die Steuereinheit ist dazu ausgebildet, die mindestens eine Steuergröße über die Steuereinheit-Schnittstelle zu der Leistungseinheit zu übertragen.

Die Leistungseinheit ist dazu ausgebildet, den mindestens einen Istwert über die Leistungseinheit-Schnittstelle zu der Steuereinheit zu übertragen.

Die Steuereinheit kann dazu ausgebildet sein, ein oder mehrere Datenpakte, beispielsweise aufweisend ein Start-Bit, ein oder mehrere Daten-Bit und ein Stop-Bit, mit einer vorgegebenen Dauer und/oder mit einem vorgegebenen zeitlichen Abstand zueinander über die Steuereinheit-Schnittstelle zu übertragen, wobei die Dauer und/oder der zeitliche Abstand vom Steuereinheit-Takt abhängig ist/sind. Die Taktgebereinstelleinheit kann dazu ausgebildet sein, den Leistungseinheit-Takt in Abhängigkeit von der vorgegebenen Dauer und/oder dem vorgegebenen zeitlichen Abstand einzustellen. Hierzu kann die Taktgebereinstelleinheit eine Zählereinheit aufweisen, die in Abhängigkeit von dem Leistungseinheit-Takt getaktet ist, wobei die Taktgebereinstelleinheit dazu ausgebildet sein kann, beim Empfangen eines Start-Bits eines jeweiligen Datenpakets einen zugehörigen Zählerstand zu bestimmen, bei Empfangen eines Stop-Bits eines jeweiligen Datenpakets einen zugehörigen Zählerstand zu bestimmen, eine Differenz zwischen einem jeweiligen Start-Bit-Zählerstand und einem jeweiligen Stop-Bit-Zählerstand zu berechnen und den Leistungseinheit-Takt in Abhängigkeit von der Differenz der Zählerstände einzustellen.

Die Steuereinheit kann dazu ausgebildet sein, Datenpakte, beispielsweise aufweisend ein Start-Bit, ein oder mehrere Daten-Bit, die beispielsweise die Steuergröße darstellen, und ein Stop-Bit, für eine bestimmte Zeitdauer oder dauerhaft, periodisch mit einer vorgebbaren bzw. vorgegebenen Zykluszeit über die Steuereinheit-Schnittstelle zur Leistungseinheit zu übertragen. Die Zykluszeit kann beispielsweise im µs-Bereich liegen und kann bevorzugt 125 µs betragen. Die Taktgebereinstelleinheit kann dazu ausgebildet sein, den Leistungseinheit-Takt in Abhängigkeit von der Zykluszeit einzustellen. Die mittels der Steuereinheit vorgegebene Zykluszeit hängt vom Steuereinheit-Takt ab. Daher kann die Zykluszeit in der Leistungseinheit dazu verwendet werden, den Leistungseinheit-Takt an den Steuereinheit-Takt anzupassen, so dass in der Leistungseinheit kein hochgenauer Leistungseinheit-Taktgeber vorgesehen sein muss. Der Steuereinheit-Taktgeber fungiert hierbei als Takt-Master und der Leistungseinheit-Taktgeber in Verbindung mit der Taktgebereinstelleinheit als Takt-Slave.

Die Taktgebereinstelleinheit kann eine Zählereinheit, beispielsweise in Form einer Capture-Compare-Einheit, aufweisen, die in Abhängigkeit von dem Leistungseinheit-Takt getaktet, d.h. inkrementiert bzw. dekrementiert, wird. Die Taktgebereinstelleinheit kann dazu ausgebildet sein, beim Empfangen eines jeweiligen Datenpakets bzw. bei einer (steigenden oder fallenden) Flanke eines Start-Bits eines jeweiligen Datenpakets einen zugehörigen Zählerstand der Zählereinheit zu bestimmen und zwischenzuspeichern, eine Differenz von Zählerständen, die zu zeitlich aufeinander folgenden Datenpaketen gehören, zu berechnen und den Leistungseinheit-Takt in Abhängigkeit von der Differenz der Zählerstände einzustellen. Die Differenz der Zählerstände kann beispielsweise mit einem zu erwartenden Referenzwert verglichen werden. Wenn die Differenz größer als der Referenzwert ist, kann darauf geschlossen werden, dass der Leistungseinheit-Takt in Bezug auf den Steuereinheit-Takt zu hoch ist, so dass die Taktgebereinstelleinheit den Leistungseinheit-Takt reduziert. Ist die Differenz kleiner als der Referenzwert, kann darauf geschlossen werden, dass der Leistungseinheit-Takt in Bezug auf den Steuereinheit-Takt zu niedrig ist, so dass die Taktgebereinstelleinheit den Leistungseinheit-Takt vergrößert.

Die Steuereinheit kann dazu ausgebildet sein, Steuereinheit-Prozesse, die mittels des Steuereinheit-Prozessors ausgeführt werden und die sich periodisch wiederholen, beispielsweise Strom-Regelungsprozesse, synchron zu den gesendeten Datenpaketen, insbesondere synchron zu einer (steigenden oder fallenden) Flanke eines Start-Bits der gesendeten Datenpakete, auszuführen. Die Leistungseinheit kann dazu ausgebildet sein, Leistungseinheit-Prozesse, die mittels des Leistungseinheit-Prozessors ausgeführt werden, die sich periodisch wiederholen und die mit den Steuereinheit-Prozessen korrespondieren, synchron zu den empfangenen Datenpaketen, insbesondere synchron zu der (steigenden oder fallenden) Flanke des Start-Bits der empfangenen Datenpakete, auszuführen. Auf diese Weise können Prozesse zwischen der Steuereinheit und der Leistungseinheit miteinander synchronisiert werden, ohne dass speziell hierfür vorgesehene Synchronisationssignale und Synchronisationsleitungen vorzusehen sind.

Die Taktgebereinstelleinheit kann dazu ausgebildet sein, beim Empfangen eines jeweiligen Datenpakets einen zugehörigen Zählerstand der Zählereinheit als lokalen Zeitstempel zu bestimmen und anhand einer Differenz zwischen dem bestimmten Zählerstand und einem vorgegebenen Phasen-Referenzwert, der in der Leistungseinheit gespeichert sein kann, den Leistungseinheit-Takt so lange zu verändern, bis die Leistungseinheit synchron zur Steuereinheit mit einer Phasen-Referenzwert-abhängigen Phasenlage arbeitet. Die Taktgebereinstelleinheit kann den Leistungseinheit-Takt als Stellgröße einer Phasenregelschleife (PLL) verwenden, wobei der Leistungseinheit-Takt so lange verändert wird, bis sich die gewünschte, Phasen-Referenzwertabhängige Phasenlage eingestellt hat.

Der Frequenzumrichter ist dazu ausgebildet, eine geschlossene Regelschleife zu implementieren. Die geschlossene Regelschleife kann beispielsweise eine Stromregelschleife zur Regelung eines Motorstroms, eine Drehmomentregelschleife zur Regelung eines Motordrehmoments, eine Vektorregelschleife einer Vektorregelung, usw. sein. Ein Regler bzw. Regelglied der Regelschleife zur Berechnung der Steuergröße ist in der Steuereinheit angeordnet. Eine Stelleinrichtung der Regelschleife ist in der Leistungseinheit angeordnet, wobei Regler und zugehörige Stelleinrichtung über die seriellen Schnittstellen in Datenverbindung stehen. Die Stelleinrichtung ist herkömmlich zur Erzeugung einer physikalischen Stellgröße ausgebildet. Die Stellgröße kann beispielsweise ein pulsweitenmoduliertes Signal sein, wobei ein Tastverhältnis des pulsweitenmodulierten Signals als Steuergröße von der Steuereinheit vorgegeben wird. Die Sensoreinheit kann eine Messeinrichtung zur Ermittlung des Istwerts der Regelschleife sein. Aufgrund der erfindungsgemäßen Aufteilung der Regelschleife zwischen der Steuereinheit und der Leistungseinheit ist es möglich, die Leistungseinheit sehr einfach aufzubauen, da die Leistungseinheit lediglich einfache und generische Aufgaben erledigt, beispielsweise die Stellgrößenerzeugung und die Istwerterfassung. Die Leistungseinheit kann daher idealerweise variantenfrei hergestellt und in einem Lager vorgehalten werden. Spezifische Regelaufgaben werden dann durch spezifische Varianten der Steuereinheit implementiert.

Die Steuergröße(n) kann/können sein: Soll-Motorströme, Soll-Motospannungen, ein Soll-Motormoment und ein Soll-Tastverhältnis einer Pulsweitenmodulation, die herkömmlich mittels der Leistungshalbleiter erzeugt wird.

Der oder die Istwert(e) kann/können sein: Motorströme, Motorspannungen, Drehwinkelstellungen, eine Zwischenkreisspannung und eine Temperatur.

Die Steuereinheit-Schnittstelle und die Leistungseinheit-Schnittstelle können eine galvanisch trennende 2-Leitungsschnittstelle bilden bzw. sein/darstellen, wobei aus Sicht der Steuereinheit auf einer ersten Leitung der beiden Leitungen Daten ausschließlich gesendet und auf einer zweiten Leitung der beiden Leitungen Daten ausschließlich empfangen werden.

Die Steuereinheit-Schnittstelle und die Leistungseinheit-Schnittstelle können jeweils Universal Asynchronous Receiver Transmitter (UART) Schnittstellen sein.

Mittels der Erfindung kann eine phasenstarre Synchronisation des Leistungseinheit-Prozessors (Slave) ohne genaue Zeitreferenz auf den Steuereinheit-Prozessor (Master) mit exakter Zeitreferenz bewirkt werden. Die Phase zwischen Master und Slave kann beliebig festgelegt werden. Dadurch kann der Datenaustausch und die Verarbeitung der Daten so abgestimmt werden, dass sich für den Frequenzumrichter eine konstante, minimale Regeltotzeit ergibt. Erfindungsgemäß ist ebenfalls die Synchronisation auf ein externes Referenzsignal (z.B. Feldbus-Takt) problemlos realisierbar.

Die beiden Prozessoren sind über eine serielle UART-Schnittstelle verbunden, wobei die UART-Schnittstelle genau einen TX-Anschluss und genau einen RX-Anschluss aufweist. Die Synchronisation des Slaves wird beispielsweise anhand der ersten Flanke des Datenpaketes des Masters realisiert. In der Steuereinheit ist eine Takt- bzw. Zeitreferenz vorgesehen. Im Slave ist ein justierbarer Oszillator vorgesehen, der der Zeitreferenz nachgeführt wird. Der justierbare Oszillator ist ein DCO (Digitally Controlled Oscillator).

Die Leistungsteil weist einen Prozessor ohne genaue Zeitreferenz auf. Der Prozessor der Leistungseinheit wird synchron zum Prozessor der Steuereinheit mit exakter Zeitreferenz (Quarz und optional Feldbus-Synchronisation) gehalten. Leistungseinheit und Steuereinheit können voneinander galvanisch getrennt sein.

Mittels der Erfindung können die Materialkosten reduziert werden. So kann anstelle eines dreikanaligen galvanisch trennenden Signalkopplers, der neben Tx- und Rx-Anschlüssen noch einen Sync-Anschluss aufweisen muss, ein lediglich zweikanaliger Signalkoppler verwendet werden. In Systemen mit Steckverbindern zwischen Leistungs- und Steuereinheit kann dadurch die Anzahl der Pins reduziert werden. Durch die reduzierte Anzahl der benötigten Leitungen reduziert sich die Anzahl der benötigten Schutzbauteile (z.B. ESD-Schutz). Weiter benötigt der Frequenzumrichter nur eine exakte Zeitreferenz (Quarzoszillator). Der Slave-Prozessor bzw. Leistungseinheit-Prozessor benötigt keine exakte Zeitreferenz, d.h. ein externer Quarzoszillator kann entfallen, so dass ein Prozessor mit weniger Pins verwendet werden kann. Weiter ist kein separater Synchronisationskanal notwendig, wodurch ebenfalls ein Prozessor mit weniger Pins verwendet werden kann. Da der Slave phasenstarr an den Master angekoppelt ist, kann die Datenaufbereitung sowie der Austausch der Daten stark vereinfacht werden. Es kann auf zusätzliche Synchronisationsmechanismen in der Software verzichtet werden.

Da eine gegebenenfalls vorhandene externe Synchronisationsquelle (Feldbus, digitaler Eingang etc.) von der Steuereinheit ausgewertet wird, kann die Steuereinheit durch zeitlich an die externe Synchronisationsquelle angepasstes, d.h. synchrones Erzeugen der Datenpakte den Leistungseinheit-Prozessor ebenfalls auf die externe Synchronisationsquelle synchronisieren, so das synchronisierte Antriebssysteme problemlos realisiert werden können.

Die Erfindung wird nachfolgend unter Bezugnahme auf die Zeichnungen detailliert beschreiben. Hierbei zeigen schematisch:
- Fig. 1: einen erfindungsgemäßen Frequenzumrichter und
- Fig. 2: einen zeitlichen Verlauf von Datenpaketen, die von einer Steuereinheit des in Fig. 1 gezeigten Frequenzumrichters an eine Leistungseinheit des in Fig. 1 gezeigten Frequenzumrichters gesendet werden.

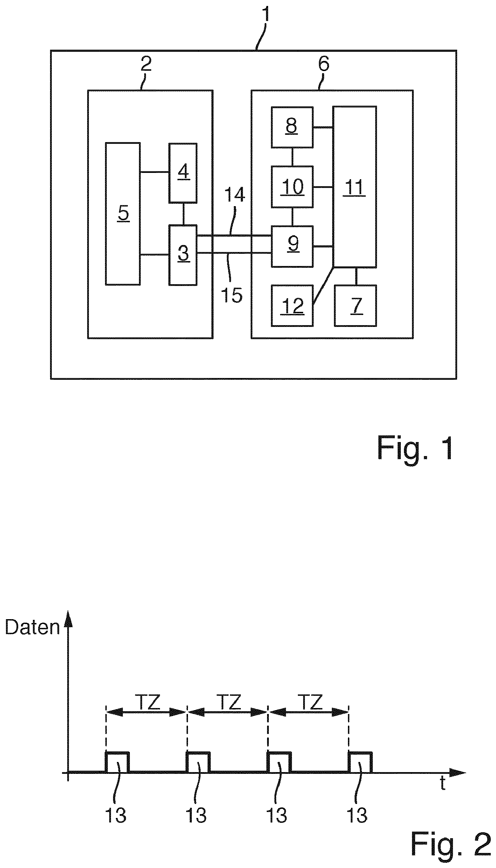

Fig. 1 zeigt einen Frequenzumrichter 1 mit einer Steuereinheit 2, die in einem nicht näher dargestellten Steuereinheit-Gehäuse angeordnet ist.

Die Steuereinheit 2 weist eine serielle 2-Draht-UART-Steuereinheit-Schnittstelle 3 auf.

Die Steuereinheit 2 weist weiter einen Steuereinheit-Taktgeber 4 in Form eines Quarzoszillators zur Erzeugung eines Steuereinheit-Taktes auf. Daten werden über die Steuereinheit-Schnittstelle 3 hinsichtlich ihres Timings in Abhängigkeit von dem Steuereinheit-Takt übertragen.

Die Steuereinheit 2 weist weiter einen Steuereinheit-Mikroprozessor 5 auf, der dazu ausgebildet ist, mindestens eine Steuergröße in Abhängigkeit von mindestens einem Istwert zu berechnen.

Der Frequenzumrichter 1 weist weiter eine Leistungseinheit 6 auf, die in einem Leistungseinheit-Gehäuse angeordnet ist und die mit der Steuereinheit 2 in serieller Datenverbindung steht.

Die Leistungseinheit 6 weist eine Anzahl, beispielsweise sechs, Leistungshalbleiter 7 auf.

Die Leistungseinheit 6 weist weiter einen Leistungseinheit-Taktgeber 8 in Form eines DCO zur Erzeugung eines einstellbaren Leistungseinheit-Taktes auf.

Die Leistungseinheit 6 weist weiter eine serielle 2-Draht-UART-Leistungseinheit-Schnittstelle 9 auf, die mit der Steuereinheit-Schnittstelle 3 zur Herstellung einer Datenverbindung wirkverbunden ist. Die Steuereinheit-Schnittstelle 3 und die Leistungseinheit-Schnittstelle 9 bilden eine galvanisch trennende 2-Leitungsschnittstelle, wobei bezogen auf die Steuereinheit 2 auf einer ersten Leitung 14 der beiden Leitungen 14, 15 Daten gesendet und auf einer zweiten Leitung 15 der beiden Leitungen 14, 15 Daten empfangen werden. Zwischen der Steuereinheit 2 und der Leistungseinheit 6 ist kein spezifischer Sync-Kanal vorgesehen.

Die Leistungseinheit 6 weist weiter eine Taktgebereinstelleinheit 10 auf, die mit der Leistungseinheit-Schnittstelle 9 in Signalverbindung steht und die dazu ausgebildet ist, in Abhängigkeit von einer Zykluszeit TZ (siehe Fig. 2), mit der Datenpakete 13 von der Steuereinheit 2 zur Leistungseinheit 6 gesendet werden, den Leistungseinheit-Takt einzustellen.

Die Leistungseinheit 6 weist weiter einen Leistungseinheit-Mikroprozessor 11 auf, der dazu ausgebildet ist, die Leistungshalbleiter 7 in Abhängigkeit von der Steuergröße und dem Leistungseinheit-Takt anzusteuern.

Die Leistungseinheit 6 weist weiter mindestens eine Sensoreinheit 12 auf, die dazu ausgebildet ist, den mindestens einen Istwert, hier beispielswiese einen Motorstrom, zu ermitteln.

Die Steuereinheit 2 ist dazu ausgebildet, die mindestens eine Steuergröße über die Steuereinheit-Schnittstelle 3 zu der Leistungseinheit 6 zu übertragen, und die Leistungseinheit 6 ist dazu ausgebildet, mindestens einen Istwert über die Leistungseinheit-Schnittstelle 9 zu der Steuereinheit 2 zu übertragen.

Die Taktgebereinstelleinheit 10 weist eine nicht näher dargestellte Zählereinheit in Form einer Capture/Compare-Einheit auf, die in Abhängigkeit von dem Leistungseinheit-Takt getaktet ist, wobei die Taktgebereinstelleinheit 10 bzw. deren Capture/Compare-Einheit dazu ausgebildet ist, beim Empfangen einer fallenden Flanke eines Start-Bits eines jeweiligen Datenpakets 13 einen zugehörigen Zählerstand auszulesen und zwischenzuspeichern, eine Differenz von Zählerständen, die zu aufeinander folgenden Datenpaketen gehören, zu berechnen und den Leistungseinheit-Takt in Abhängigkeit von der Differenz der Zählerstände einzustellen. Die Differenz wird hierzu mit einem Referenzwert verglichen, wobei für den Fall, dass die Differenz größer als der Referenzwert ist, der Leistungseinheit-Takt um ein Maß verringert wird, das von einer Differenz zwischen dem Referenzwert und der Zählerstandsdifferenz abhängig ist. Für den Fall, dass die Differenz kleiner als der Referenzwert ist, wird der Leistungseinheit-Takt um ein Maß vergrößert, das von der Differenz zwischen dem Referenzwert und der Zählerstandsdifferenz abhängig ist.

Dieses Nachführen des Leistungseinheit-Takts in Abhängigkeit von der Zykluszeit TZ und damit in Abhängigkeit vom Steuereinheit-Takt kann einmalig, beispielsweise in einer Initialisierungsroutine erfolgen. Alternativ kann das Nachführen auch zyklisch in bestimmten zeitlichen Abständen, beispielsweise bei jedem Empfangen eines Datenpakets 13, erfolgen. Weiter alternativ kann in der Initialisierungsroutine zunächst der Leistungseinheit-Takt an den Steuereinheit-Takt wie oben beschrieben angeglichen werden. Danach kann lediglich ein Zählerwert der Capture/Compare-Einheit an der Flanke des Start-Bits eines jeweiligen Datenpakets ermittelt werden, wobei der derart ermittelte Zählerwert darauf überwacht wird, ob er einem Referenzwert entspricht. Wenn beispielsweise ein Zählerüberlauf bei abgeglichenem Leistungseinheit-Takt und Steuereinheit-Takt genau einmal pro Zykluszeit TZ der Datenpakete 13 erfolgt, bleibt der ermittelte Zählerwert konstant. Verändert sich nun der Zählerwert, ist dies ein Zeichen dafür, dass der Leistungseinheit-Takt bezogen auf den Steuereinheit-Takt driftet, so dass der Leistungseinheit-Takt mittels der Taktgebereinstelleinheit 10 nachzuführen ist.

Der Frequenzumrichter 1 ist dazu ausgebildet ist, eine geschlossene Motorstrom-Regelschleife zu implementieren, wobei ein Regler der Regelschleife zur Berechnung der Steuergröße in der Steuereinheit 2 angeordnet ist, eine Stelleinrichtung der Regelschleife in der Leistungseinheit 6 angeordnet ist und die Sensoreinheit 12 eine Messeinrichtung der Regelschleife bildet.

Die Steuereinheit 2 ist dazu ausgebildet, Steuereinheit-Prozesse, die sich wiederholen, synchron zu den gesendeten Datenpaketen 13 auszuführen. Entsprechend ist die Leistungseinheit 6 dazu ausgebildet, Leistungseinheit-Prozesse, die sich wiederholen, synchron zu den empfangenen Datenpaketen 13 auszuführen.

Beispielsweise kann die Steuereinheit 2 in einem jeweiligen Datenpaket 13 die momentane Steuergröße zur Leistungseinheit 6 übertragen und die Leistungseinheit 6 kann in einem vorgegebenen zeitlichen Abstand zu dem Start-Bit eines jeweiligen Datenpakets 13 den oder die Istwerte zu der Steuereinheit 2 übertragen.

Weiter kann die Steuereinheit 2 basierend auf dem oder den empfangenen Istwerten einen Regelalgorithmus ausführen und die Leistungseinheit 6 kann basierend auf der Steuergröße ein Tastverhältnis einer Pulsweitenmodulation einstellen. Die Steuergröße kann vorliegend beispielswiese ein Soll-Tastverhältnis einer Pulsweitenmodulation sein und einer der Istwerte kann ein Motorstrom sein. Es versteht sich, dass weitere, insbesondere kaskadierte, Regelschleifen vorgesehen sein können, wie sie bei Frequenzumrichtern üblich sind.

Der Leistungseinheit-Taktgeber 8, die serielle Leistungseinheit-Schnittstelle 9, die Taktgebereinstelleinheit 10, der Leistungseinheit-Prozessor 11 und gegebenenfalls die Sensoreinheit 12 bzw. Teile davon können auf einem einzelnen Mikrocontroller integriert sein.

## Patentansprüche

1. Frequenzumrichter (1), aufweisend:
- eine Steuereinheit (2), aufweisend:
- eine serielle Steuereinheit-Schnittstelle (3),
- einen Steuereinheit-Taktgeber (4) zur Erzeugung eines Steuereinheit-Taktes, wobei Daten über die serielle Steuereinheit-Schnittstelle (3) in Abhängigkeit von dem Steuereinheit-Takt übertragen werden, und
- einen Steuereinheit-Prozessor (5), der dazu ausgebildet ist, mindestens eine Steuergröße in Abhängigkeit von mindestens einem Istwert zu bestimmen, und
- eine Leistungseinheit (6), die mit der Steuereinheit (2) in Datenverbindung steht und aufweist:
- eine Anzahl von Leistungshalbleitern (7),
- einen Leistungseinheit-Taktgeber (8) in Form eines Digitally Controlled Oscillator, DCO, zur Erzeugung eines einstellbaren Leistungseinheit-Taktes,
- eine serielle Leistungseinheit-Schnittstelle (9), die mit der Steuereinheit-Schnittstelle (3) zur Herstellung einer Datenverbindung koppelbar ist,
- eine Taktgebereinstelleinheit (10), die mit der Leistungseinheit-Schnittstelle (9) in Signalverbindung steht und die dazu ausgebildet ist, in Abhängigkeit von Signalen, die von der Leistungseinheit (6) auf der Leistungseinheit-Schnittstelle (9) empfangen werden, den Leistungseinheit-Takt einzustellen,
- einen Leistungseinheit-Prozessor (11), der dazu ausgebildet ist, die Leistungshalbleiter (7) in Abhängigkeit von der Steuergröße und dem Leistungseinheit-Takt anzusteuern, und
- mindestens eine Sensoreinheit (12), die dazu ausgebildet ist, den mindestens einen Istwert zu ermitteln,
- wobei die Steuereinheit (2) dazu ausgebildet ist, die mindestens eine Steuergröße über die Steuereinheit-Schnittstelle (3) zu der Leistungseinheit (6) zu übertragen, und
- wobei die Leistungseinheit (6) dazu ausgebildet ist, den mindestens einen Istwert über die Leistungseinheit-Schnittstelle (9) zu der Steuereinheit (2) zu übertragen,
- wobei der Frequenzumrichter (1) dazu ausgebildet ist, eine geschlossene Regelschleife zu implementieren, insbesondere eine Stromregelschleife, wobei ein Regler der Regelschleife zur Berechnung der Steuergröße in der Steuereinheit (2) angeordnet ist, eine Stelleinrichtung der Regelschleife in der Leistungseinheit (6) angeordnet ist und die Sensoreinheit (12) eine Messeinrichtung der Regelschleife bildet.

2. Frequenzumrichter (1) nach Anspruch 1, **dadurch gekennzeichnet, dass**
- die Steuereinheit (2) dazu ausgebildet ist, Datenpakte (13) mit einer vorgegebenen Dauer und/oder mit einem vorgegebenen zeitlichen Abstand zwischeneinander über die Steuereinheit-Schnittstelle (3) zu übertragen,
- wobei die Taktgebereinstelleinheit (10) dazu ausgebildet ist, den Leistungseinheit-Takt in Abhängigkeit von der vorgegebenen Dauer und/oder dem vorgegebenen zeitlichen Abstand einzustellen.

3. Frequenzumrichter (1) nach Anspruch 1 oder 2, **dadurch gekennzeichnet, dass**
- die Steuereinheit (2) dazu ausgebildet ist, Datenpakte (13) periodisch mit einer vorgegebenen Zykluszeit (TZ) über die Steuereinheit-Schnittstelle (3) zu übertragen,
- wobei die Taktgebereinstelleinheit (10) dazu ausgebildet ist, den Leistungseinheit-Takt in Abhängigkeit von der Zykluszeit (TZ) einzustellen.

4. Frequenzumrichter (1) nach Anspruch 3, **dadurch gekennzeichnet, dass**
- die Taktgebereinstelleinheit (10) eine Zählereinheit aufweist, die in Abhängigkeit von dem Leistungseinheit-Takt getaktet ist, wobei die Taktgebereinstelleinheit (10) dazu ausgebildet ist, beim Empfangen eines jeweiligen Datenpakets (13) einen zugehörigen Zählerstand zu bestimmen, eine Differenz von Zählerständen, die zu aufeinander folgenden Datenpaketen (13) gehören, zu berechnen und den Leistungseinheit-Takt in Abhängigkeit von der Differenz der Zählerstände einzustellen.

5. Frequenzumrichter (1) nach einem der Ansprüche 2 bis 4, **dadurch gekennzeichnet, dass**
- die Steuereinheit (2) dazu ausgebildet ist, Steuereinheit-Prozesse, die sich wiederholen, synchron zu den gesendeten Datenpaketen (13) auszuführen, und
- die Leistungseinheit (6) dazu ausgebildet ist, Leistungseinheit-Prozesse, die sich wiederholen, synchron zu den empfangenen Datenpaketen (13) auszuführen.

6. Frequenzumrichter (1) nach Anspruch 4 oder 5, **dadurch gekennzeichnet, dass**
- die Taktgebereinstelleinheit (10) dazu ausgebildet ist, beim Empfangen eines jeweiligen Datenpakets (13) einen zugehörigen Zählerstand als lokalen Zeitstempel zu bestimmen, und anhand einer Differenz zwischen dem bestimmten Zählerstand und einem vorgegebenen Phasen-Referenzwert den Leistungseinheit-Takt derart anzupassen, dass die Leistungseinheit synchron zur Steuereinheit mit einer Phasen-Referenzwert-abhängigen Phasenlage arbeitet.

7. Frequenzumrichter (1) nach einem der vorhergehenden Ansprüche, **dadurch gekennzeichnet, dass**
- die mindestens eine Steuergröße ausgewählt ist aus einer Gruppe aufweisend folgende Steuergrößen:
- Soll-Motorströme,
- Soll-Motospannungen,
- ein Soll-Motormoment und
- ein Soll-Tastverhältnis einer Pulsweitenmodulation.

8. Frequenzumrichter (1) nach einem der vorhergehenden Ansprüche, **dadurch gekennzeichnet, dass**
- der mindestens eine Istwert ausgewählt ist aus einer Gruppe aufweisend folgende Istwerte:
- Motorströme,
- Motorspannungen,
- Drehwinkelstellungen einer Rotorwelle,
- eine Zwischenkreisspannung und
- eine Temperatur.

9. Frequenzumrichter (1) nach einem der vorhergehenden Ansprüche, **dadurch gekennzeichnet, dass**
- die Steuereinheit-Schnittstelle (3) und die Leistungseinheit-Schnittstelle (9) eine galvanisch trennende 2-Leitungsschnittstelle bilden, wobei bezogen auf die Steuereinheit (2) auf einer ersten Leitung (14) der beiden Leitungen (14, 15) Daten gesendet und auf einer zweiten Leitung (15) der beiden Leitungen (14, 15) Daten empfangen werden.

10. Frequenzumrichter (1) nach einem der vorhergehenden Ansprüche, **dadurch gekennzeichnet, dass**
- die Steuereinheit-Schnittstelle (3) und die Leistungseinheit-Schnittstelle (9) Universal Asynchronous Receiver Transmitter (UART) Schnittstellen sind.

## Claims

1. Frequency converter (1), having:
- a control unit (2), having:
- a serial control unit interface (3),
- a control unit clock pulse generator (4) for generating a control unit clock pulse, wherein data are transmitted via the serial control unit interface (3) depending on the control unit clock pulse, and
- a control unit processor (5) which is designed to define at least one control parameter depending on at least one actual value, and
- a power unit (6) which has a data connection to the control unit (2) and has:
- a number of power semiconductors (7),
- a power unit clock pulse generator (8) in the form of a digitally controlled oscillator, DCO, for generating an adjustable power unit clock pulse,
- a serial power unit interface (9) which is connectable to the control unit interface (3) in order to set up a data connection,
- a clock pulse generator adjustment unit (10) which has a signal connection to the power unit interface (9) and which is designed to adjust the power unit clock pulse depending on signals which are received by the power unit (6) on the power unit interface (9),
- a power unit processor (11) which is designed to control the power semiconductors (7) depending on the control parameter and the power unit clock pulse, and
- at least one sensor unit (12) which is designed to determine the at least one actual value,
- wherein the control unit (2) is designed to transmit the at least one control parameter via the control unit interface (3) to the power unit (6), and
- wherein the power unit (6) is designed to transmit the at least one actual value via the power unit interface (9) to the control unit (2),
- wherein the frequency converter (1) is designed to implement a closed control loop, in particular a current control loop, wherein a controller of the control loop for calculating the control parameter is disposed in the control unit (2), an adjustment device of the control loop is disposed in the power unit (6), and the sensor unit (12) forms a measuring device of the control loop.

2. Frequency converter (1) according to Claim 1, **characterized in that**
- the control unit (2) is designed to transmit data packets (13) with a predefined duration and/or with a predefined time interval between one another via the control unit interface (3),
- wherein the clock pulse generator adjustment unit (10) is designed to adjust the power unit clock pulse depending on the predefined duration and/or the predefined time interval.

3. Frequency converter (1) according to Claim 1 or 2, **characterized in that**
- the control unit (2) is designed to transmit data packets (13) periodically with a predefined cycle time (TZ) via the control unit interface (3),
- wherein the clock pulse generator adjustment unit (10) is designed to adjust the power unit clock pulse depending on the cycle time (TZ).

4. Frequency converter (1) according to Claim 3, **characterized in that**
- the clock pulse generator adjustment unit (10) has a counter unit which is clocked depending on the power unit clock pulse, wherein the clock pulse generator adjustment unit (10) is designed to define an associated counter status on reception of a respective data packet (13), to calculate a difference between counter statuses belonging to successive data packets (13) and to adjust the power unit clock pulse depending on the difference between the counter statuses.

5. Frequency converter (1) according to one of Claims 2 to 4, **characterized in that**
- the control unit (2) is designed to perform repeated control unit processes synchronously with the transmitted data packets (13), and
- the power unit (6) is designed to perform repeated power unit processes synchronously with the received data packets (13).

6. Frequency converter (1) according to Claim 4 or 5, **characterized in that**
- the clock pulse generator adjustment unit (10) is designed to define an associated counter status as a local time stamp on reception of a respective data packet (13) and to adapt the power unit clock pulse on the basis of a difference between the defined counter status and a predefined phase reference value in such a way that the power unit operates synchronously with the control unit with a phase relationship which is dependent on the phase reference value.

7. Frequency converter (1) according to one of the preceding claims, **characterized in that**
- the at least one control parameter is selected from a group having the following control parameters:
- reference motor currents,
- reference motor voltages,
- a reference motor torque, and
- a reference pulse duty factor of a pulse width modulation.

8. Frequency converter (1) according to one of the preceding claims, **characterized in that**
- the at least one actual value is selected from a group having the following actual values:
- motor currents,
- motor voltages,
- rotation angle settings of a rotor shaft,
- a DC link voltage, and
- a temperature.

9. Frequency converter (1) according to one of the preceding claims, **characterized in that**
- the control unit interface (3) and the power unit interface (9) form an electrically isolating 2-line interface, wherein, in relation to the control unit (2), data are transmitted on a first line (14) of the two lines (14, 15) and data are received on a second line (15) of the two lines (14, 15).

10. Frequency converter (1) according to one of the preceding claims, **characterized in that**
- the control unit interface (3) and the power unit interface (9) are Universal Asynchronous Receiver Transmitter (UART) interfaces.

## Revendications

1. Convertisseur de fréquence (1), comportant :
- une unité de commande (2) comportant :
- une interface série d'unité de commande (3),
- un générateur d'horloge d'unité de commande (4) destiné à générer une horloge d'unité de commande, des données étant transmises par le biais de l'interface série d'unité de commande (3) en fonction de l'horloge d'unité de commande, et
- un processeur d'unité de commande (5) qui est conçu pour déterminer au moins une grandeur de commande en fonction d'au moins une valeur réelle, et
- une unité de puissance (6) qui se trouve en liaison de données avec l'unité de commande (2) et comporte :
- un certain nombre de semi-conducteurs de puissance (7),
- un générateur d'horloge d'unité de puissance (8) sous la forme d'un oscillateur à commande numérique, DCO, destiné à générer une horloge réglable d'unité de puissance,
- une interface série d'unité de puissance (9) qui peut être couplée à l'interface d'unité de commande (3) afin d'établir une liaison de données,
- une unité de réglage de générateur d'horloge (10), qui se trouve en liaison de signal avec l'interface d'unité de puissance (9) et qui est conçue pour régler l'horloge d'unité de puissance en fonction de signaux qui sont reçus par l'unité de puissance (6) sur l'interface d'unité de puissance (9),
- un processeur d'unité de puissance (11) qui est conçu pour commander les semi-conducteurs de puissance (7) en fonction de la grandeur de commande et de l'horloge d'unité de puissance, et
- au moins une unité de capteur (12) qui est conçue pour déterminer ladite au moins une valeur réelle,
- l'unité de commande (2) étant conçue pour transmettre ladite au moins une grandeur de commande à l'unité de puissance (6) par le biais de l'interface d'unité de commande (3), et
- l'unité de puissance (6) étant conçue pour transmettre ladite au moins une valeur réelle à l'unité de commande (2) par le biais de l'interface d'unité de puissance (9),
- le convertisseur de fréquence (1) étant conçu pour mettre en œuvre une boucle de régulation fermée, notamment une boucle de régulation de courant, un régulateur de la boucle de régulation étant disposé dans l'unité de commande (2) pour le calcul de la grandeur de commande, un dispositif de réglage de la boucle de régulation étant conçu dans l'unité de puissance (6) et l'unité de capteur (12) constituant un dispositif de mesure de la boucle de régulation.

2. Convertisseur de fréquence (1) selon la revendication 1, **caractérisé en ce que**
- l'unité de commande (2) est conçue pour transmettre par le biais de l'interface d'unité de commande (3) des paquets de données (13) ayant une durée prédéterminée et/ou espacés les uns des autres d'un intervalle de temps prédéterminé,
- l'unité de réglage de générateur d'horloge (10) étant conçue pour régler l'horloge d'unité de puissance en fonction de la durée prédéterminée et/ou de l'intervalle de temps prédéterminé.

3. Convertisseur de fréquence (1) selon la revendication 1 ou 2, **caractérisé en ce que**
- l'unité de commande (2) est conçue pour transmettre périodiquement des paquets de données (13) avec un temps de cycle (TZ) prédéterminé par le biais de l'interface d'unité de commande (3),
- l'unité de réglage de générateur d'horloge (10) est conçue pour régler l'horloge d'unité de puissance en fonction du temps de cycle (TZ).

4. Convertisseur de fréquence (1) selon la revendication 3, **caractérisé en ce que**
- l'unité de réglage de générateur d'horloge (10) comporte un compteur qui est cadencé en fonction de l'horloge d'unité de puissance, l'unité de réglage de générateur d'horloge (10) étant conçue pour déterminer un état de compteur associé lors de la réception d'un paquet de données respectif (13), pour calculer une différence entre des états de compteur qui appartiennent à des paquets de données successifs (13), et pour régler l'horloge d'unité de puissance en fonction de la différence entre états du compteur.

5. Convertisseur de fréquence (1) selon l'une quelconque des revendications 2 à 4, **caractérisé en ce que**
- l'unité de commande (2) est conçue pour exécuter des processus d'unité de commande qui se répètent de manière synchrone avec les paquets de données émis (13), et
- l'unité de puissance (6) est conçue pour exécuter des processus d'unité de puissance qui se répètent de manière synchrone avec les paquets de données reçus (13).

6. Convertisseur de fréquence (1) selon la revendication 4 ou 5, **caractérisé en ce que**
- l'unité de réglage de générateur d'horloge (10) est conçue pour déterminer un état de compteur associé en tant que marqueur temporel local lors de la réception d'un paquet de données respectif (13), et pour ajuster l'horloge d'unité de puissance sur la base d'une différence entre l'état de compteur déterminé et une valeur de référence de phase prédéterminée, de telle sorte que l'unité de puissance fonctionne en synchronisme avec l'unité de commande avec une position de phase dépendant de la valeur de référence de phase.

7. Convertisseur de fréquence (1) selon l'une quelconque des revendications précédentes, **caractérisé en ce que**
- ladite au moins une grandeur de commande est sélectionnée dans un groupe comprenant les grandeurs de commande suivantes :
- des courants de moteur cibles,
- des tensions de moteur cibles,
- un couple moteur cible et
- un rapport cyclique cible d'une modulation de largeur d'impulsion.

8. Convertisseur de fréquence (1) selon l'une quelconque des revendications précédentes, **caractérisé en ce que**
- ladite au moins une valeur réelle est sélectionnée dans un groupe comprenant les valeurs réelles suivantes :
- des courants de moteur,
- des tensions de moteur,
- des positions d'angle de rotation d'un arbre de rotor,
- une tension de circuit intermédiaire et
- une température.

9. Convertisseur de fréquence (1) selon l'une quelconque des revendications précédentes, **caractérisé en ce que**
- l'interface d'unité de commande (3) et l'interface d'unité de puissance (9) forment une interface à 2 lignes à séparation galvanique, par rapport à l'unité de commande (2), des données étant émises sur une première ligne (14) des deux lignes (14, 15) et des données étant reçues sur une deuxième ligne (15) des deux lignes (14, 15).

10. Convertisseur de fréquence (1) selon l'une quelconque des revendications précédentes, **caractérisé en ce que**
- l'interface d'unité de commande (3) et l'interface d'unité de puissance (9) sont des interfaces UART (Universal Asynchronous Receiver Transmitter).
